**Europäisches Patentamt**

**European Patent Office**

**Office européen des brevets**

(11) Veröffentlichungsnummer: **0 579 862 A1**

# EUROPÄISCHE PATENTANMELDUNG

(21) Anmeldenummer: **92112720.5**

(22) Anmeldetag: **24.07.92**

(51) Int. Cl.5: **G11C 11/409**, G11C 7/00

(43) Veröffentlichungstag der Anmeldung:
**26.01.94 Patentblatt 94/04**

(84) Benannte Vertragsstaaten:
**AT BE CH DE DK ES FR GB GR IT LI LU MC NL PT SE**

(71) Anmelder: **SIEMENS AKTIENGESELLSCHAFT**
**Wittelsbacherplatz 2**
**D-80333 München(DE)**

(72) Erfinder: **Meyer, Willibald, Dipl.-Ing.**
**Anette-Kolb-Anger 15**
**W-8000 München 83(DE)**
Erfinder: **Wirth, Norbert, Dipl.-Phys.**
**Mistralstrasse 4**
**W-8044 Unterschleissheim(DE)**

(54) **Integrierte Halbleiterspeicheranordnung.**

(57) Eine integrierte Halbleiterspeicheranordnung mit einem aus einer Vielzahl von Abschnitten bestehenden Speicherbereich, wobei jedem Speicherbereichsabschnitt eine Vielzahl von mit jeweils zwei Bitleitungen verbundenen Leseverstärkern zugeordnet ist, mit einer Vielzahl von parallelen, zum Speicherbereich führenden Datenleitungen, wobei jeweils eine Datenleitung zu einem Speicherbereichsabschnitt führt, und mit jeweils an beiden Enden einer jeden Datenleitung angeordneten Lese/Schreib-Verstärkerschaltern, wobei jeweils der am dem Speicherbereichsabschnitt zugewandten Ende der Datenleitung angeordnete Lese/Schreib-Verstärkerschalter über Auswahlschalter mit den Leseverstärkern dieses Speicherbereichsabschnitts verbunden ist.

FIG 1

Bei Halbleiterspeicheranordnungen, bei denen zusätzlich zum eigentlichen Speicherbereich noch weitere Schaltungen auf demselben Chip mit integriert sind, wie beispielsweise bei Bildspeichern, werden immer höhere Datenraten und/oder eine größere Anzahl von Datenweiterverarbeitungsschaltungen auf demselben Chip gefordert. Da die Geschwindigkeit des Zugriffs auf den Speicherbereich, der meistens als DRAM ausgebildet ist, nicht beliebig gesteigert werden kann, müssen bei jedem Zugriff immer mehr Bits gleichzeitig und parallel zum bzw. vom Speicherbereich übertragen werden.

Klassische Standard-DRAMs arbeiten heute mit bis zu 16 internen parallelen Doppeldatenleitungen. Eine solche Doppeldatenleitung besteht aus zwei parallelen Datenleitungen, von denen jeweils die eine das zur anderen Datenleitung komplementäre Signal führt. Durch diese Maßnahme kann eine kurze Schaltzeit der Leseverstärker erzielt werden und damit eine kürzere Signallaufzeit vom eigentlichen Speicherbereich zu den Datenzugängen einer Speicheranordnung.
Bildspeicher sollen jedoch beispielsweise Blöcke von bis zu 32x9 = 288 Bits gleichzeitig im wahlfreien Zugriff aus bzw. zu einem 4Mb großen Zellenfeld an bzw. von mehrere(n) Datenzugänge(n) mit Zwischenspeichern und Schieberegistern liefern. Das würde bei Verwendung einer zwei Datenleitungen umfassenden Doppeldatenleitung für das genannte Beispiel zu 576 parallelen Leitungen führen.

Das der Erfindung zugrunde liegende Problem besteht darin, die Anzahl der benötigten Leitungen bei hoher Datenrate zu reduzieren.

Das Problem wird gelöst durch eine integrierte Halbleiterspeicheranordnung mit einem aus einer Vielzahl von Abschnitten bestehenden Speicherbereich, wobei jedem Speicherbereichsabschnitt eine Vielzahl von mit jeweils zwei Bitleitungen verbundenen Leseverstärkern zugeordnet ist, mit einer Vielzahl von parallelen, zum Speicherbereich führenden Datenleitungen, wobei jeweils eine Datenleitung zu einem Speicherbereichsabschnitt führt, und mit jeweils an beiden Enden einer jeden Datenleitung angeordneten Lese/Schreib-Verstärkerschaltern, wobei jeweils der am dem Speicherbereichsabschnitt zugewandten Ende der Datenleitung angeordnete Lese/Schreib-Verstärkerschalter über Auswahlschalter mit den Leseverstärkern dieses Speicherbereichsabschnitts verbunden ist.

Bei der erfindungsgemäßen integrierten Halbleiterspeicheranordnung wird also nur eine einfache Datenleitung statt einer Doppeldatenleitung benutzt, wobei an beiden Enden dieser Datenleitung Lese/Schreib-Verstärkerschalter angeordnet sind. Wegen der oft erheblichen Länge dieser Datenleitungen, die zudem einen erheblichen Kapazitätsbelag aufweisen, müssen die darauf zu übertragenden Signale vor der Übertragung verstärkt werden. Da diese Datenleitungen bidirektional verwendet werden, sind also an beiden Enden der Datenleitungen Verstärker nötig, von denen jeweils einer für den Lese- und der andere für den Schreibbetrieb der Speicheranordnung aktiv wird. In den Lese/Schreib-Verstärkerschaltern sind außer den Verstärkern noch Schalter vorgesehen, mit deren Hilfe die Signale in der Betriebsart, für die die Verstärker nicht vorgesehen sind, um die Verstärker herum geleitet werden.

In einer vorteilhaften Ausgestaltung der erfindungsgemäßen integrierten Halbleiterspeicheranordnung sind die am dem Speicherbereich abgewandten Ende der Datenleitungen angeordneten Lese/Schreib-Verstärkerschalter mit einer oder mehreren Schaltungsanordnungen verbunden, wobei bei mehreren Schaltungsanordnungen zur Weiterverarbeitung von Daten diese über Auswahlschalter mit den jeweiligen Lese/Schreib-Verstärkerschaltern verbunden sind.

Diese Schaltungsanordnungen zur Weiterverarbeitung von Daten können dabei als Zwischenspeicher oder als Schieberegister oder als Datenein/ausgangsschaltungen gebildet sein. Es sind aber auch andere Schaltungsanordnungen denkbar.

Da innerhalb des Speicherbereichs zwei Bitleitungen mit jeweils komplementärer Information vorhanden sind, können diese entweder in den Leseverstärkern oder in den Lese/Schreib-Verstärkerschaltern auf eine Datenleitung reduziert werden. Die Lese/Schreib-Verstärkerschalter sind somit entweder über eine oder zwei Verbindungsleitungen mit den jeweiligen Speicherbereichsabschnitten und den Schaltungsanordnungen zur Weiterverarbeitung von Daten verbunden.

Die Erfindung soll nun anhand von Ausführungsbeispielen mit Hilfe von Figuren näher erläutert werden. Es zeigen dabei
Figuren 1 und 2
Blockschaltbilder möglicher Ausführungsformen von Teilen erfindungsgemäßer Halbleiterspeicheranordnungen und
Figuren 3 bis 6
mögliche Ausführungsformen von Lese/Schreib-Verstärkerschaltern.

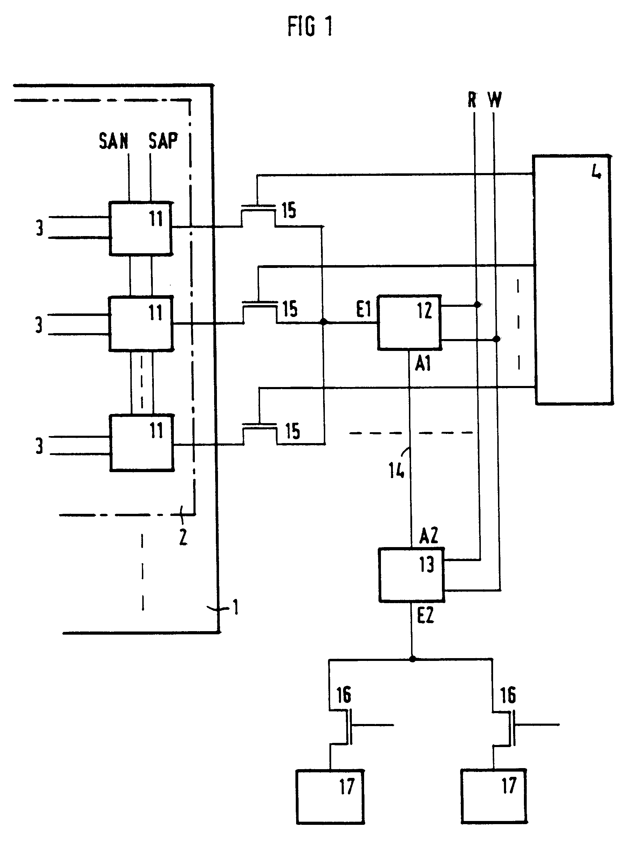

Bei der Ausführungsform gemäß Figur 1 ist ein Speicherbereich 1 einer erfindungsgemäßen integrierten Halbleiterspeicheranordnung in eine Vielzahl von Speicherbereichsabschnitte 2 unterteilt. Einem jeden solchen Abschnitt 2 sind eine Vielzahl von Leseverstärkern 11 zugeordnet, die ihrerseits jeweils zwei Bitleitungen 3 versorgen. Die Leseverstärker 11 werden über jeweils zwei Leitungen mittels zweier Signale SAN und SAP aktiviert.

Die Leseverstärker 11 jeweils eines Speicherbereichsabschnitts 2 sind über Auswahlschalter 15 mit dem Eingang E1 eines ersten Lese/Schreib-Verstärkerschalters 12 verbunden, wobei diese Auswahlschalter 15 von einem 1ausN-Bit-Decoder 4 angesteuert werden. Der Ausgang A1 des ersten Lese/Schreib-Verstärkerschalters 12 ist über eine Datenleitung 14 mit dem Ausgang A2 eines zweiten Lese/Schreib-Verstärkerschalters 13 verbunden, dessen Eingang E2 seinerseits über Auswahlschalter 16 mit Schaltungsanordnungen zur Weiterverarbeitung von Daten 17 verbunden ist. Die Auswahlschalter 16 werden ebenfalls von einem nicht dargestellten 1ausN-Bit-Decoder angesteuert. Die Schaltungsanordnungen 17 können beispielsweise Schieberegister, Zwischenspeicher oder Datenein/ausgangsschaltungen sein. Sowohl der erste als auch der zweite Lese/Schreib-Verstärkerschalter 12, 13 werden mittels zweier Leitungen von einem Lesesignal R und von einem Schreibsignal W beaufschlagt, abhängig davon, ob gelesen oder geschrieben werden soll.

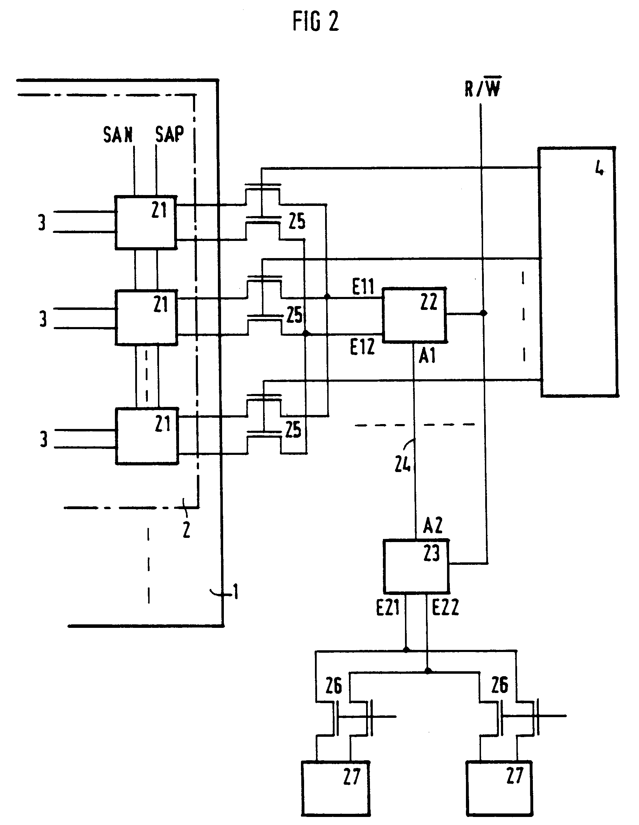

In Figur 2 ist eine zweite Ausführungsform einer erfindungsgemäßen integrierten Halbleiterspeicheranordnung gezeigt, die sich von der Ausführungsform gemäß Figur 1 im wesentlichen dadurch unterscheidet, daß die beiden von einem Leseverstärker 21 versorgten Bitleitungen 3 nicht im Leseverstärker 21 selbst, sondern erst im ersten Lese/Schreib-Verstärkerschalter 22 auf eine Datenleitung 24 reduziert werden. Die einzelnen Leseverstärker 21 eines Speicherbereichsabschnitts 2 sind also über jeweils zwei Auswahlschalter 25, die wiederum von einem 1ausN-Bit-Decoder 4 angesteuert werden, mit den Eingängen E11, E12 des Lese/Schreib-Verstärkerschalters 22 verbunden. Auch der zweite Lese/Schreib-Verstärkerschalter 23 ist mit seinen beiden Eingängen E21, E22 über jeweils zwei Auswahlschalter 26 mit den jeweiligen Schaltungsanordnungen zur Weiterverarbeitung von Daten 27 verbunden.

Außerdem werden bei der Ausführungsform gemäß Figur 2, im Gegensatz zu der nach Figur 1, die beiden Lese/Schreib-Verstärkerschalter 22, 23 nur mittels einer Leitung von einem Lese/nicht-Schreibsignal R/W̄ aktiviert.

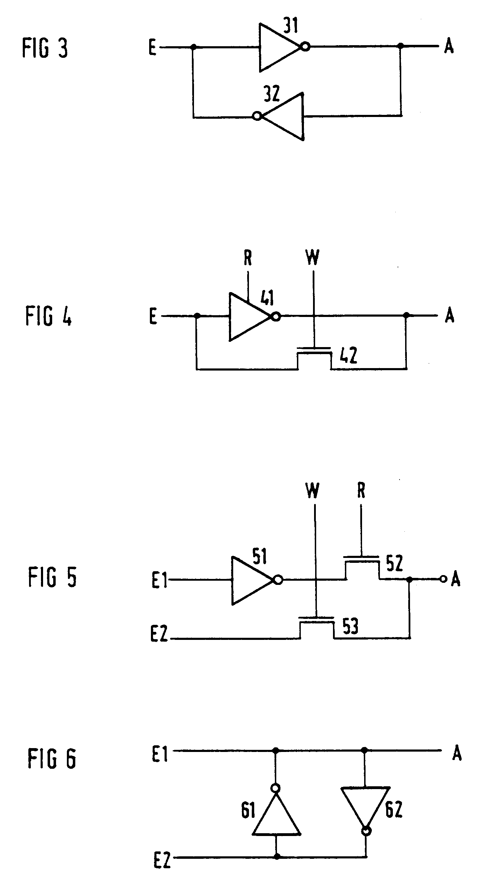

In den Figuren 3 bis 6 sind verschiedene Ausführungsformen von Lese/Schreib-Verstärkerschaltern 12, 13 bzw. 22, 23 dargestellt.

So zeigt Figur 3 einen Lese/Schreib-Verstärkerschalter, bei dem einem ersten Verstärker 31, der einen Eingang E und einen Ausgang A aufweist, ein zweiter Verstärker 32 parallel geschaltet ist, jedoch in umgekehrter Richtung. Bei diesem Lese/Schreib-Verstärkerschalter ist kein Lesesignal R bzw. Schreibsignal W nötig, da die beiden Verstärker 31, 32 unidirektional sind, und durch ihre Anordnung selbst als Schalter für die jeweilige Übertragungsrichtung wirken.

Wenn statt der in Figur 3 dargestellten Verstärker 31, 32 sogenannten 3-State-Buffer verwendet werden, so können diese mittels des Lesesignals R oder des Schreibsignals W in einen hochohmigen Zustand geschaltet werden. 3-State-Buffer können entweder für den Verstärker 31 oder den Verstärker 32 oder aber für beide Verstärker 31 und 32 verwendet werden.

Figur 4 zeigt einen Lese/Schreib-Verstärkerschalter, bei dem einem 3-State-Buffer 41, der von einem Lesesignal R aktiviert wird und einen Eingang E sowie einen Ausgang A aufweist, ein n-Kanal-FET-Schalter 42, der von einem Schreibsignal W angesteuert wird, parallel geschaltet ist.

Wird statt des 3-State-Buffers 41 nur ein Verstärker 51 verwendet, wie in Figur 5 gezeigt ist, so ist es vorteilhaft, zu diesem einen weiteren n-Kanal-FET-Schalter 52, der nun statt des 3-State-Buffers 41 von dem Lesesignal R angesteuert wird, in Serie zu schalten.

Wie aus Figur 5 hervorgeht, ist der Eingang E1 des Verstärkers 51 nicht mit dem einen Anschluß des Schalters 53 verbunden, dieser bildet einen weiteren Eingang E2, so daß diese Ausführungsform eines Lese/Schreib-Verstärkerschalters in die Halbleiterspeicheranordnung gemäß Figur 2 eingesetzt werden kann.

Die Ausführungsformen gemäß den Figuren 3 und 4 lassen sich ohne weiteres entsprechend abändern.

Statt der in Figur 5 dargestellten n-Kanal-FET-Schalter 52, 53 können natürlich auch p-Kanal-FET-Schalter verwendet werden; es müssen dann allerdings das Lesesignal R und das Schreibsignal W vertauscht werden.

Es ist außerdem möglich, eine Parallelschaltung aus einem n-Kanal-FET und einem p-Kanal-FET als Schalter zu verwenden, so daß sich die jeweiligen Vorteile dieser beiden Varianten ergänzen.

In Figur 6 ist eine Ausführungsform eines Lese/Schreib-Verstärkerschalters gezeigt, wie sie in die Halbleiterspeicheranordnung gemäß Figur 2 eingesetzt werden kann.

Zwischen den beiden Eingängen E1 und E2 ist die Parallelschaltung zweier entgegengesetzt wirkender Inverterverstärker 61, 62 angeordnet, wobei der Eingang E1 gleichzeitig den Ausgang A des Leseverstärkerschalters bildet.

Statt der Inverterverstärker 61, 62 können auch 3-State-Buffer verwendet werden, die dann von dem Lesesignal R bzw. dem Schreibsignal W angesteuert werden können.

Das Lesesignal R und das Schreibsignal W können aber auch dazu verwendet werden, jeweils einen Schalter anzusteuern, wobei der eine dieser Schalter die beiden Inverterverstärker 61, 62 an ihre positive und der andere Schalter die Inverterverstärker 61, 62 an ihre negative Versorgungsspannung anschließt. Das Lese- und Schreibsignal R, W können bei ausreichender Leistungsabgabe aber auch direkt als Versorgungsspannungen für die Inverterverstärker 61, 62 dienen.

**Patentansprüche**

1. Integrierte Halbleiterspeicheranordnung mit einem aus einer Vielzahl von Abschnitten (2) bestehenden Speicherbereich (1), wobei jedem Speicherbereichsabschnitt (2) eine Vielzahl von mit jeweils zwei Bitleitungen (3) verbundenen Leseverstärkern (11; 21) zugeordnet ist,
mit einer Vielzahl von parallelen, zum Speicherbereich (1) führenden Datenleitungen (14; 24), wobei jeweils eine Datenleitung (14; 24) zu einem Speicherbereichsabschnitt (2) führt, und mit jeweils an beiden Enden einer jeden Datenleitung (14; 24) angeordneten Lese/Schreib-Verstärkerschaltern (12, 13; 22, 23) , wobei jeweils der am dem Speicherbereichsabschnitt (2) zugewandten Ende der Datenleitung (14; 24) angeordnete Lese/Schreib-Verstärkerschalter (12; 22) über Auswahlschalter (15; 25) mit den Leseverstärkern (11; 21) dieses Speicherbereichsabschnitts (2) verbunden ist.

2. Integrierte Halbleiterspeicheranordnung nach Anspruch 1, bei der die am dem Speicherbereich (1) abgewandten Ende der Datenleitungen (14; 24) angeordneten Lese/Schreib-Verstärkerschalter (13; 23) mit einer oder mehreren Schaltungsanordnungen zur Weiterverarbeitung von Daten (17; 27) verbunden sind, wobei bei mehreren Schaltungsanordnungen zur Weiterverarbeitung von Daten (17; 27) diese über Auswahlschalter (16; 26) mit den jeweiligen Lese/Schreib-Verstärkerschaltern (13; 23) verbunden sind.

3. Integrierte Halbleiterspeicheranordnung nach einem der Ansprüche 1 oder 2, bei der die Schaltungsanordnungen zur Weiterverarbeitung von Daten als Zwischenspeicher oder als Schieberegister oder als Datenein/ausgangsschaltungen gebildet sein können.

4. Integrierte Halbleiterspeicheranordnung nach einem der Ansprüche 1 bis 3, bei der die Lese/Schreib-Verstärkerschalter (12, 13; 22, 23) jeweils über eine oder zwei Verbindungsleitungen mit den Speicherbereichsabschnitten (2) und den Schaltungsanordnungen verbunden sind.

## FIG 1

# FIG 2

FIG 3

FIG 4

FIG 5

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y<br>A | EP-A-0 481 084 (FUJITSU)<br>* Spalte 1, Zeile 20 - Spalte 2, Zeile 27;<br>Abbildung 1 *<br>--- | 1,3,4<br>2 | G11C11/409<br>G11C7/00 |
| Y | IEEE JOURNAL OF SOLID STATE CIRCUITS<br>Bd. SC-21, Nr. 5, Oktober 1986, NEW YORK<br>Seiten 643 - 648<br>FUJII ET AL 'A 50uA Standby 1Mx1/256Kx4<br>CMOS DRAM with High-Speed Sense Amplifier'<br>* Seite 644, linke Spalte, Zeile 5 - Seite<br>645, rechte Spalte, Zeile 23; Abbildungen<br>3,5 *<br>--- | 1,3,4 | |
| A | DE-A-4 138 102 (MITSUBISHI DENKI)<br>* Abbildungen 1,2,6 *<br>* Spalte 1, Zeile 3 - Spalte 4, Zeile 6 *<br>* Spalte 24, Zeile 64 - Spalte 25, Zeile<br>58 *<br><br>----- | 1,2 | |

**RECHERCHIERTE SACHGEBIETE (Int. Cl.5)**

G11C

Der vorliegende Recherchenbericht wurde für alle Patentansprüche erstellt

| Recherchenort | Abschlußdatum der Recherche | Prüfer |
|---|---|---|
| DEN HAAG | 26 MAERZ 1993 | CARDUS, A. |